# EUROPEAN PATENT APPLICATION

(11) **EP 4 682 691 A1**
(43) Date of publication of application: **21.01.2026**
(21) Application number: 24791897.2
(22) Date of filing: 10.04.2024
(51) Int. Cl.: G06F 3/041

(54) **TOUCH-CONTROL DISPLAY PANEL, TOUCH-CONTROL DISPLAY APPARATUS AND ELECTRONIC DEVICE**

(30) Priority: 18.04.2023 CN 202310439410; 17.05.2023 CN 202310559604
(71) Applicant: Huawei Technologies Co., Ltd., Shenzhen, Guangdong 518129 (CN)
(72) Inventor: ZHANG, Gaofan, Shenzhen, Guangdong 518129 (CN); ZHANG, Junyong, Shenzhen, Guangdong 518129 (CN)
(74) Representative: Gill Jennings & Every LLP
(86) International application number: PCT/CN2024/087036
(87) International publication number: WO 2024/217312

(57) **Abstract**

This application provides a touch display panel, a touch display apparatus, and an electronic device. The touch display panel includes a display layer, an encapsulation layer, and a touch layer group that are sequentially disposed in a stacked manner. A plurality of touch units arranged in an array, a first metal trace, and a pad are disposed in the touch layer group in an active area, and at least one touch unit includes a first touch electrode area and a second touch electrode area. A first metal mesh is disposed in the first touch electrode area, and a second metal mesh is disposed in the second touch electrode area. A second metal trace is disposed in at least one of the first touch electrode area and the second touch electrode area, the second metal trace is used to connect a metal mesh in a touch electrode area in which the second metal trace is located to one end of the first metal trace, and the other end of the first metal trace is connected to the pad. During implementation of this application, resistance compensation for traces between the touch units and the pad can be implemented, and a bezel of the touch display panel is not occupied, thereby ensuring a small bezel size.

## Description

This application claims priorities to Chinese Patent Application No. 202310439410.5, filed with the China National Intellectual Property Administration on April 18, 2023 and entitled "TOUCH DISPLAY PANEL AND TOUCH DISPLAY APPARATUS", and to Chinese Patent Application No. 202310559604.9, filed with the China National Intellectual Property Administration on May 17, 2023 and entitled "TOUCH DISPLAY PANEL, TOUCH DISPLAY APPARATUS, AND ELECTRONIC DEVICE", both of which are incorporated herein by reference in their entireties.

### TECHNICAL FIELD

This application relates to the field of touch display technologies, and in particular, to a touch display panel, a touch display apparatus, and an electronic device.

### BACKGROUND

On a touch display panel, touch units, namely, touch sensors, are directly made on a thin-film encapsulation layer of the touch display panel through coating and photoetching. Each touch unit is configured to identify a position at which an object such as a user finger or a stylus touches an operation panel. In addition, the touch units need to be connected to a same touch control module through a pad located on a side of the touch display panel, to transmit sensing signals of the touch units to the touch control module.

Because the touch units arranged in an array are distributed at different positions, and a position of the pad is fastened on the side of the touch display panel, trace resistances between touch units in different columns or different rows and the pad are not equal, that is, trace resistances between the touch units and the touch control module are not equal. As a result, the signals transmitted by the touch units to the touch control module are not uniform, and consequently, the touch display panel is prone to accidental touch determining or an insensitive touch response, which affects use.

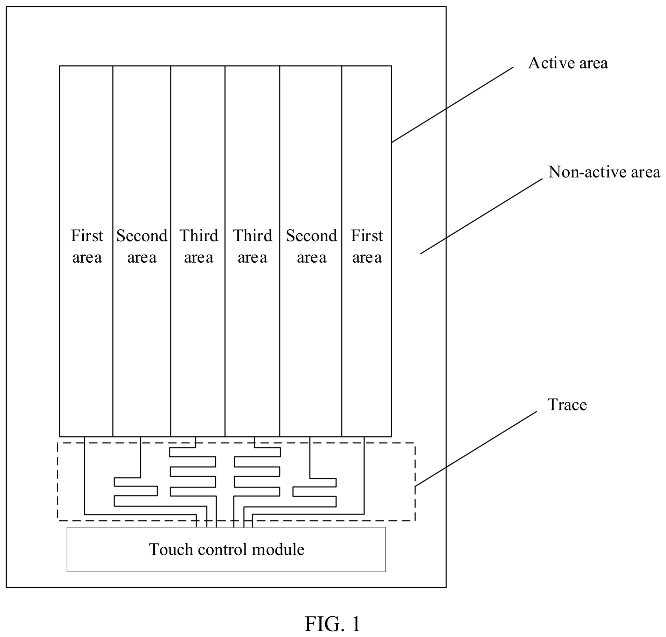

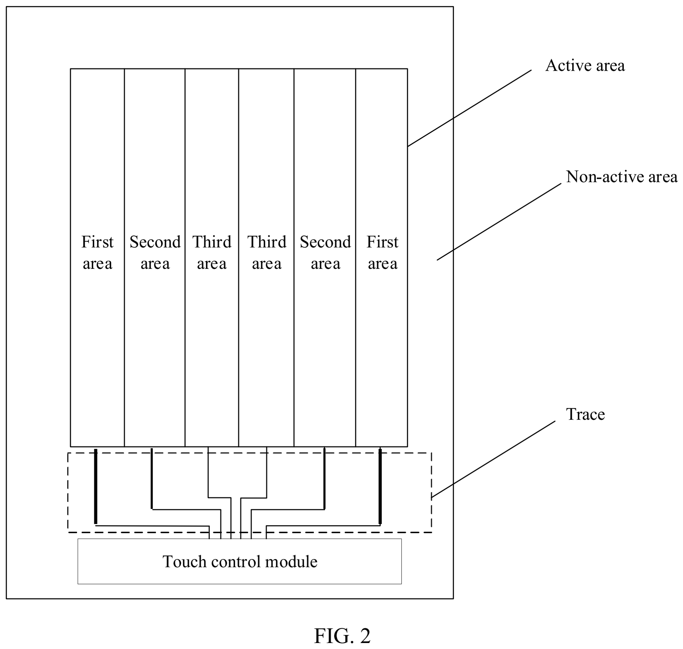

For a problem that the trace resistances between the touch units and the touch control module are not equal, a method used in a conventional technology is to compensate for traces through which the touch units are connected to the touch control module in a non-active area (Non-active Area, NA area), for example, adjust lengths or widths of the traces. For example, the traces through which the touch units are connected to the touch control module may be shown in FIG. 1. From a first area on a leftmost or rightmost side to a third area in the middle, each area includes at least one touch unit, and a length of a trace through which the touch unit is connected to the touch control module gradually increases. Alternatively, the traces through which the touch units are connected to the touch control module may be shown in FIG. 2. From a first area on a leftmost or rightmost side to a third area in the middle, a width of a trace through which a touch unit is connected to the touch control module gradually decreases. However, regardless of whether a routing manner in FIG. 1 or a routing manner in FIG. 2 is used, specific space needs to be reserved in the non-active area to increase a trace length or a trace width. As a result, a bezel of the touch display panel is increased, which is not conducive to narrowing the bezel of the touch display panel.

### SUMMARY

This application provides a touch display panel, a touch display apparatus, and an electronic device, so that resistance compensation for a trace between a touch unit and a pad in a touch electrode area can be implemented, and a bezel of the touch display panel is not occupied, thereby ensuring a small bezel size.

According to a first aspect, an embodiment of this application provides a touch display panel. The touch display panel includes a display layer, an encapsulation layer, and a touch layer group that are sequentially disposed in a stacked manner, and the touch layer group is located on a side that is of the encapsulation layer and that is away from the display layer.

During specific implementation, a plurality of touch units arranged in an array, a first metal trace, and a pad are disposed in the touch layer group, and at least one touch unit includes a first touch electrode area and a second touch electrode area. A first metal mesh is disposed in the first touch electrode area, a second metal mesh is disposed in the second touch electrode area, and the first metal mesh and the second metal mesh form an induction capacitor. A second metal trace is disposed in at least one of the first touch electrode area and the second touch electrode area, the second metal trace may be used to connect a metal mesh in a touch electrode area in which the second metal trace is located to one end of the first metal trace, and the other end of the first metal trace is connected to the pad. In this case, the second metal trace may be used to adjust a trace resistance between the at least one touch unit and the pad.

In this embodiment of this application, the second metal trace is additionally disposed in the first touch electrode area or the second touch electrode area in an active area. In this way, resistance compensation for the traces between the touch units and the pad can be implemented, that is, resistance compensation for traces between the touch units and a touch control module can be implemented, and a bezel of the touch display panel is not occupied, so that the bezel of the touch display panel is reduced, thereby ensuring the small bezel size.

For example, the plurality of touch units are disposed in the active area of the touch display panel, and the pad is disposed in a non-active area of the touch display panel. Optionally, the first metal trace may be disposed in the active area, or the first metal trace may be disposed in the non-active area.

With reference to the first aspect, in a first possible implementation, a plurality of pixel areas arranged in an array and a light-shielding area between adjacent pixel areas are disposed at the display layer, and orthographic projections of the first metal mesh, the second metal mesh, and the second metal trace onto the display layer fall within the light-shielding areas.

During implementation of this embodiment of this application, the orthographic projections of the first metal mesh, the second metal mesh, and the second metal trace onto the display layer are all in the light-shielding areas. In this way, resistance compensation for the traces on the touch display panel can be implemented in the first touch electrode area in the active area while a light emitting effect of the touch display panel is considered, so that the bezel of the touch display panel is reduced, thereby ensuring the small bezel size.

With reference to the first aspect or the first possible implementation of the first aspect, in a second possible implementation, the first metal mesh includes a plurality of third metal traces, and the second metal mesh includes a plurality of fourth metal traces.

With reference to the second possible implementation of the first aspect, in a third possible implementation, a trace width of the second metal trace, a trace width of the first metal trace, and a trace width of the third metal trace are the same. During implementation of this embodiment of this application, processing of the touch display panel is convenient, and the trace widths of the metal traces are consistent, thereby facilitating signal stability.

With reference to the first aspect or any one of the foregoing possible implementations of the first aspect, in a fourth possible implementation, the touch layer group is formed by stacking a first metal layer, an insulation layer, and a second metal layer in a thickness direction of the touch display panel, and the insulation layer is disposed between the first metal layer and the second metal layer. The at least one touch unit is disposed at the first metal layer, or the at least one touch unit is disposed at the second metal layer, or the at least one touch unit is disposed at the first metal layer and the second metal layer. In this embodiment of this application, routing of the touch units may be performed at both the first metal layer and the second metal layer, thereby ensuring flexible routing and convenient design.

With reference to the fourth possible implementation of the first aspect, in a fifth possible implementation, the at least one touch unit is disposed at the first metal layer, or the at least one touch unit is disposed at the second metal layer. When the second metal trace is disposed in the first touch electrode area of the at least one touch unit, the second metal trace is directly connected to the first metal mesh.

During implementation of this embodiment of this application, the second metal trace is directly connected to the first metal mesh, so that a quantity of through holes can be reduced.

With reference to the fourth possible implementation of the first aspect, in a sixth possible implementation, the at least one touch unit is disposed at the first metal layer, or the at least one touch unit is disposed at the second metal layer. When the second metal trace is disposed in the second touch electrode area of the at least one touch unit, the second metal trace is directly connected to the second metal mesh.

During implementation of this embodiment of this application, the second metal trace is directly connected to the second metal mesh, so that a quantity of through holes can be reduced.

With reference to the fourth possible implementation of the first aspect, in a seventh possible implementation, the at least one touch unit is disposed at the first metal layer and the second metal layer, and a first through hole is provided at the insulation layer. When the second metal trace is disposed in the first touch electrode area of the at least one touch unit, the second metal trace is located at the first metal layer, the first metal mesh in the first touch electrode area is located at the second metal layer, and the second metal trace is connected to the first metal mesh through the first through hole.

In this embodiment of this application, the first metal mesh and the second metal trace are disposed at different layers. In this way, resistance compensation for the traces between the touch units and the pad can be implemented without affecting a routing layout of the first metal mesh, and the bezel of the touch display panel is not occupied, so that the bezel of the touch display panel is reduced, thereby ensuring the small bezel size.

With reference to the fourth possible implementation of the first aspect, in an eighth possible implementation, the at least one touch unit is disposed at the first metal layer and the second metal layer, and a second through hole is provided at the insulation layer. When the second metal trace is disposed in the second touch electrode area of the at least one touch unit, the second metal trace is located at the first metal layer, the second metal mesh in the second touch electrode area is located at the second metal layer, and the second metal trace is connected to the second metal mesh through the second through hole.

In this embodiment of this application, the first metal mesh and the second metal trace are disposed at different layers of the second touch electrode area. In this way, resistance compensation for the traces between the touch units and the pad can be implemented without affecting a routing layout of the first metal mesh, and the bezel of the touch display panel is not occupied, so that the bezel of the touch display panel is reduced, thereby ensuring the small bezel size.

With reference to the first aspect or any one of the foregoing possible implementations of the first aspect, in a ninth possible implementation, the at least one touch unit is arranged in a first row or a first column of the array. During implementation of this embodiment of this application, resistance compensation for the touch units is initiated at a start portion of the touch display panel, so that signals of all the touch units on the touch display panel are even and consistent.

According to a second aspect, an embodiment of this application provides a touch display apparatus. The touch display apparatus includes a touch control module and the touch display panel according to the first aspect or any one of the foregoing possible implementations of the first aspect.

According to a third aspect, an embodiment of this application provides an electronic device. The electronic device includes a controller and the touch display apparatus according to the second aspect.

For specific implementations and beneficial effects of the foregoing aspects and the possible implementations of the foregoing aspects, refer to each other.

### BRIEF DESCRIPTION OF DRAWINGS

FIG. 1 is a diagram of trace compensation of an existing touch display panel;
FIG. 2 is a diagram of other trace compensation of an existing touch display panel;
FIG. 3 is a block diagram of a structure of an electronic device according to an embodiment of this application;
FIG. 4 is a block diagram of a structure of a touch display apparatus according to an embodiment of this application;
FIG. 5 is a planar diagram of a touch display panel according to an embodiment of this application;
FIG. 6 is a diagram of a cross-sectional structure of an active area of the touch display panel shown in FIG. 5 along a line P-P;
FIG. 7 is a diagram of a planar structure of a touch display panel according to an embodiment of this application;
FIG. 8 is a diagram of a planar structure of a touch unit according to an embodiment of this application;
FIG. 9A is a diagram of an exploded structure of the touch unit shown in FIG. 8;
FIG. 9B is a diagram of another exploded structure of the touch unit shown in FIG. 8;
FIG. 10 is a diagram of positions of a touch unit and a pixel area shown in FIG. 8;
FIG. 11A and FIG. 11B are diagrams of traces on a touch display panel according to an embodiment of this application;
FIG. 12 is a diagram of a three-dimensional structure of a touch unit at a first metal layer and a second metal layer according to an embodiment of this application;
FIG. 13 is a diagram of another planar structure of a touch unit according to an embodiment of this application;
FIG. 14A and FIG. 14B are diagrams of other traces on a touch display panel according to an embodiment of this application;
FIG. 15 is a diagram of another three-dimensional structure of a touch unit at a first metal layer and a second metal layer according to an embodiment of this application;
FIG. 16 is a diagram of another planar structure of a touch unit according to an embodiment of this application;
FIG. 17A is a diagram of an exploded structure of the touch unit shown in FIG. 16;
FIG. 17B is a diagram of another exploded structure of the touch unit shown in FIG. 16;
FIG. 18 is a diagram of another three-dimensional structure of a touch unit at a first metal layer and a second metal layer according to an embodiment of this application;
FIG. 19 is a diagram of another planar structure of a touch unit according to an embodiment of this application; and
FIG. 20 is a diagram of another three-dimensional structure of a touch unit at a first metal layer and a second metal layer according to an embodiment of this application.

### DESCRIPTION OF EMBODIMENTS

Implementations of technical solutions of this application are further described below in detail with reference to the accompanying drawings.

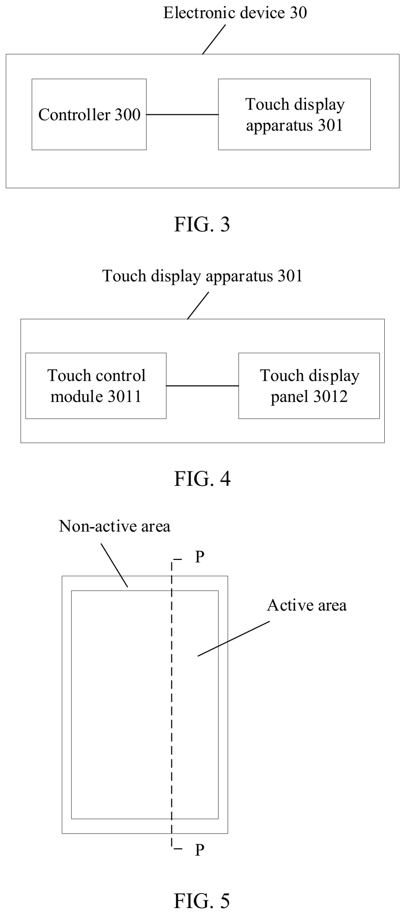

FIG. 3 is a block diagram of a structure of an electronic device according to an embodiment of this application. As shown in FIG. 3, the electronic device 30 includes a controller 300 and a touch display apparatus 301 connected to the controller 300. For example, the electronic device 30 may be an intelligent consumer electronic device such as a mobile phone, a tablet computer, or a notebook computer, or a wearable electronic device such as augmented reality (augmented reality, AR) device, virtual reality (virtual reality, VR) device, a smartwatch, or a smart band, or a vehicle-mounted device such as a vehicle-mounted infotainment.

The controller 300 may perform signal interaction with the touch display apparatus 301. For example, the controller 300 may send a control instruction to the touch display apparatus 301, and receive a sensing signal returned by the touch display apparatus 301. The controller 300 determines a position of a touch operation based on the sensing signal. When determining the position of the touch operation, the controller 300 may send a response signal to the touch display apparatus 301. For example, the controller 300 may be specifically implemented as a system on chip (System on Chip, SOC), a micro control unit (Micro Control Unit, MCU), a central processing unit (central processing unit, CPU), another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, or a discrete hardware component.

An embodiment of this application further provides a touch display apparatus 301. A block diagram of a structure of the touch display apparatus 301 is shown in FIG. 4. The touch display apparatus 301 includes a touch control module 3011 and a touch display panel 3012 connected to the touch control module 3011.

In a mutual-capacitance touch display panel, the touch control module 3011 provides a touch drive signal to the touch display panel 3012 based on a control instruction sent by a controller 300, and sends, to the controller 300, a sensing signal received from the touch display panel 3012. In a self-capacitance touch display panel, the touch control module 3011 detects a sensing signal returned by the touch display apparatus 301, and sends the sensing signal to a controller 300. For example, the touch control module 3011 may be specifically implemented as a flexible printed circuit (Flexible Printed Circuit, FPC).

A plurality of touch units arranged in an array are disposed on the touch display panel 3012 in an active area, and each touch unit includes a first touch electrode located in a first touch electrode area and a second touch electrode located in a second touch electrode area. When an object such as a user finger or a stylus touches an operation panel, a mutual capacitance between the first touch electrode and the second touch electrode changes, and the touch unit may send, to the touch control module 3011, a signal indicating that the mutual capacitance changes; or a capacitance between the first touch electrode and the ground, namely, a self-capacitance of the first touch electrode, changes, or a capacitance between the second touch electrode and the ground, namely, a self-capacitance of the second touch electrode, changes, and the touch unit may send, to the touch control module 3011, a signal indicating that the self-capacitance of the first touch electrode changes or a signal indicating that the self-capacitance of the second touch electrode changes.

For example, the touch display panel 3012 may be specifically implemented as an organic light-emitting diode (Organic Light-Emitting Diode, OLED) display panel. In a driving manner, the touch display panel 3012 may be a display panel that is in the OLED display panel and that uses an active driving manner, that is, may be an active matrix organic light-emitting diode (Active Matrix Organic Light-Emitting Diode, AMOLED) display panel.

In this embodiment of this application, by changing traces on the touch display panel in the touch display apparatus in the active area, resistance compensation for traces between the touch units and a pad is implemented, that is, resistance compensation for traces between the touch units and the touch control module is implemented, and a bezel of the touch display panel is not occupied, thereby ensuring a small bezel size.

The following describes a structure of the touch display panel in detail with reference to the accompanying drawings.

FIG. 5 is a planar diagram of a touch display panel according to an embodiment of this application. As shown in FIG. 5, the touch display panel includes an active area (Active Area, AA area) and a non-active area. The active area is a display active area of the touch display panel, and corresponds to a pixel area of the touch display panel. The active area is used to display an image. The non-active area does not have a function of displaying an image, and is used to set a functional module such as a display driver module.

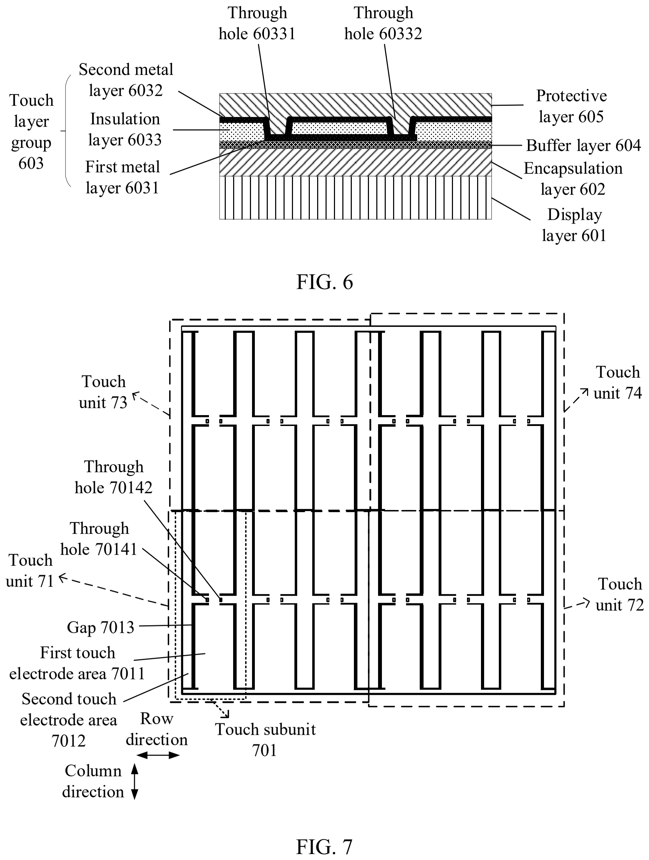

FIG. 6 is a diagram of a cross-sectional structure of an active area of the touch display panel shown in FIG. 5 along a line P-P. As shown in FIG. 6, the active area of the touch display panel includes a display layer 601, an encapsulation layer 602, and a touch layer group 603 that are sequentially disposed in a stacked manner. It should be noted that sequential stacking indicates a stacking sequence of the display layer 601, the encapsulation layer 602, and the touch layer group 603, and does not indicate that there is no other layer structure among the display layer 601, the encapsulation layer 602, and the touch layer group 603. For example, a buffer layer (namely, a buffer layer) 604 may be disposed between the encapsulation layer 602 and the touch layer group 603. The buffer layer 604 is configured to serve as a base material of the touch layer group. For another example, the touch display panel further includes a protective layer 605. The protective layer 605 is located on a side that is of the touch layer group 603 and that is away from the display layer 601, and the protective layer 605 is configured to protect layer structures such as the touch layer group 603, the buffer layer 604, the encapsulation layer 602, and the display layer 601.

The touch layer group 603 is located on a side that is of the encapsulation layer 602 and that is away from the display layer 601. In addition, the touch layer group 603 is formed by stacking a first metal layer 6031, an insulation layer 6033, and a second metal layer 6032 in a thickness direction of the touch display panel, and the insulation layer 6033 is disposed between the first metal layer 6031 and the second metal layer 6032. The insulation layer 6033 isolates the first metal layer 6031 from the second metal layer 6032, and a plurality of through holes, such as a through hole 60331 and a through hole 60332, are provided at the insulation layer 6033. The touch display panel is specifically formed through deposition and etching. Therefore, when the through holes are provided at the insulation layer 6033, a conductive material for manufacturing the second metal layer 6032 is deposited in the through holes, so that the first metal layer 6031 and the second metal layer 6032 may be electrically connected through the conductive material in the through holes.

FIG. 7 is a diagram of a planar structure of a touch display panel according to an embodiment of this application. As shown in FIG. 7, a plurality of touch units arranged in an array are disposed in a touch layer group. In FIG. 7, for example, touch units in two rows and two columns are specifically disposed in the touch layer group, that is, the touch display panel includes, for example, a touch unit 71, a touch unit 72, a touch unit 73, and a touch unit 74.

The touch unit 71 is used as an example. The touch unit 71 includes at least one touch subunit 701. It may be understood that a quantity of touch subunits 701 is set according to a design requirement, and the quantity of touch control subunits included in the touch unit is not limited herein.

The touch unit 71 includes a first touch electrode area 7011 and a second touch electrode area 7012, and there is a gap 7013 between the first touch electrode area 7011 and the second touch electrode area 7012. The gap 7013 is configured to isolate a connection between a trace of the first touch electrode area 7011 and a trace of the second touch electrode area 7012.

In touch units in a same column, first touch electrode areas are connected in a column direction, to form a signal transmission channel in the column direction. In touch units in a same row, second touch electrode areas are connected in a row direction, to form a signal transmission channel in the row direction. On the touch display panel, at least one touch unit may be disposed at a first metal layer, or at least one touch unit may be disposed at a second metal layer, or at least one touch unit may be disposed at a first metal layer and a second metal layer.

During specific implementation, for example, the touch unit shown in FIG. 7 is specifically disposed at the second metal layer. A part of the second touch electrode area 7012 on the left of the first touch electrode area 7011 may reach the first metal layer through a through hole 70141. A trace at the first metal layer bypasses the trace of the first touch electrode area 7011. The trace of the first metal layer is connected to a part of the second touch electrode area 7012 on the right of the first touch electrode area 7011 through a through hole 70142. In this way, the second touch electrode areas 7012 are connected in the row direction.

A first metal mesh is disposed in the first touch electrode area 7011, and the first metal mesh may also be referred to as a first conductive pattern. A second metal mesh is disposed in the second touch electrode area 7012, and the second metal mesh may be referred to as a second conductive pattern. The first metal mesh and the second metal mesh form an induction capacitor, where the induction capacitor is configured to sense a capacitance change generated when an object such as a user finger or a stylus touches an operation panel, to determine a position at which the object performs a touch operation on the panel.

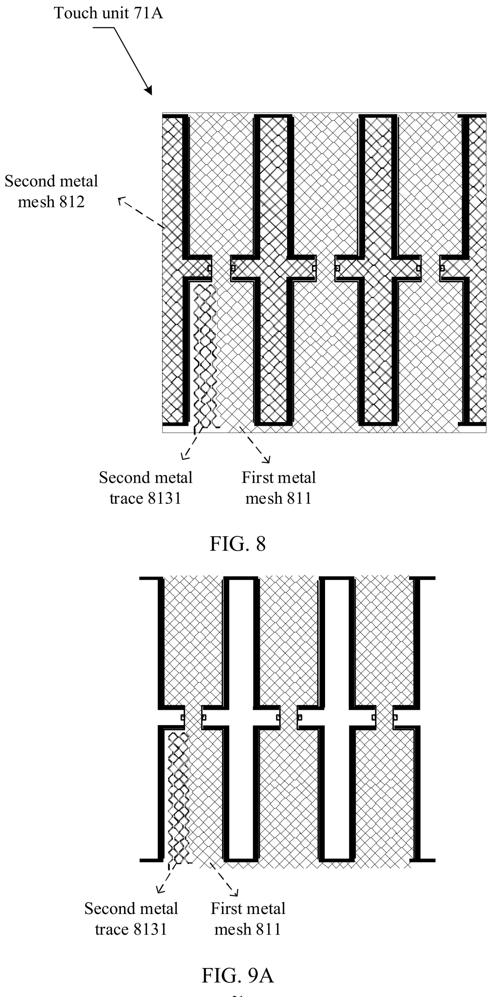

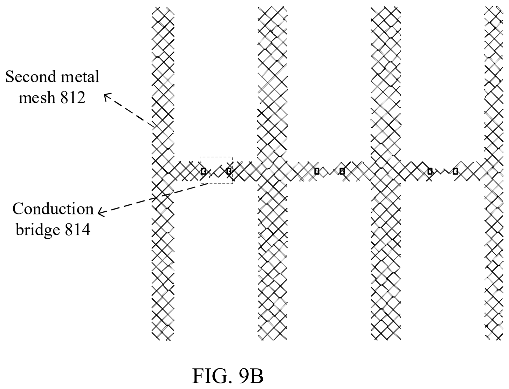

In some feasible implementations, the at least one touch unit is disposed at the first metal layer, or the at least one touch unit is disposed at the second metal layer, and a second metal trace is disposed in a first touch electrode area of the at least one touch unit. FIG. 8 is a diagram of a planar structure of a touch unit according to an embodiment of this application. FIG. 9A is a diagram of an exploded structure of the touch unit shown in FIG. 8. FIG. 9B is a diagram of another exploded structure of the touch unit shown in FIG. 8. As shown in FIG. 8 and FIG. 9A, a first metal mesh 811 and a second metal trace 8131 are disposed in a first touch electrode area of a touch unit 71A. In this case, the second metal trace 8131 and the first metal mesh 811 are located at a same metal layer, and the second metal trace 8131 may be directly connected to the first metal mesh 811.

As shown in FIG. 8 and FIG. 9B, a second metal mesh 812 is disposed in a second touch electrode area of the touch unit 71A, and the second metal mesh 812 and the first metal mesh 811 are located at a same layer.

For example, the second metal mesh 812, the first metal mesh 811, and the second metal trace 8131 are located at the first metal layer, or the second metal mesh 812, the first metal mesh 811, and the second metal trace 8131 are located at the second metal layer.

In addition, a conduction bridge 814 is further disposed in the second touch electrode area. For example, the second metal mesh is located at the second metal layer. The through hole 70141 and the through hole 70142 that are shown in FIG. 7 and fourth metal traces that the second metal mesh 812 includes and that route at the first metal layer form the conduction bridge 814.

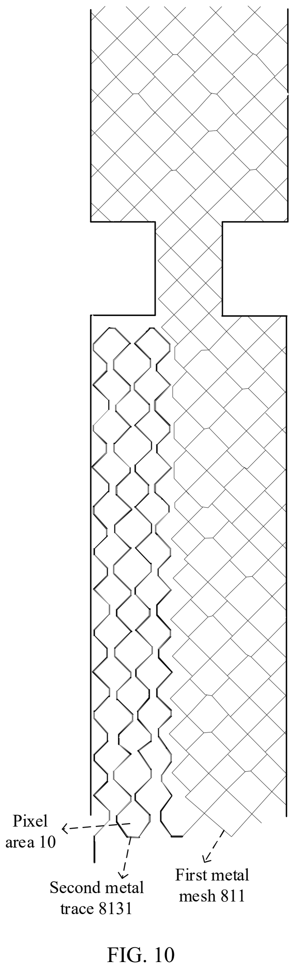

Optionally, in some feasible implementations, FIG. 10 is a diagram of positions of a touch unit and a pixel area shown in FIG. 8. As shown in FIG. 10, the touch display panel includes a plurality of pixel areas 10 arranged in an array and a light-shielding area between every two adjacent pixel areas. The pixel areas 10 and the light-shielding areas are located at the display layer 601 shown in FIG. 6 on the touch display panel. It may be understood that the pixel area 10 is an area used for light emitting; and the light-shielding area is an area in which light cannot be emitted, where an area at the display layer other than the pixel area 10 may be considered as a light-shielding area.

Orthographic projections of the first metal mesh 811 and the second metal trace 8131 onto the display layer are in the light-shielding areas. Similarly, an orthographic projection of the second metal mesh (not shown in FIG. 10) onto the display layer is also in the light-shielding areas.

During implementation of this embodiment of this application, the orthographic projections of the first metal mesh, the second metal mesh, and the second metal trace onto the display layer are all in the light-shielding areas. In this way, resistance compensation for the traces on the touch display panel can be implemented in the first touch electrode area in an active area while a light emitting effect of the touch display panel is considered, so that a bezel of the touch display panel is reduced, thereby ensuring a small bezel size.

Optionally, in some feasible implementations, the first metal mesh 811 includes a plurality of third metal traces, and the second metal mesh 812 includes the plurality of fourth metal traces. In this case, a trace width of the second metal trace 8131, a trace width of the third metal trace, and a trace width of the fourth metal trace are within a preset range. An upper limit of the preset range is defined to avoid blocking light emitting of the pixel areas, and a lower limit of the preset range is related to a manufacturing process of the touch display panel. In this embodiment of this application, the trace width of the second metal trace, the trace width of the third metal trace, and the trace width of the fourth metal trace are controlled to be within the preset range, to prevent the trace widths of the metal traces from being excessively wide and thereby blocking light emission of the pixel areas.

Further, the trace width of the second metal trace 8131, the trace width of the third metal trace, and the trace width of the fourth metal trace are the same. During implementation of this embodiment of this application, processing of the touch display panel is convenient, and the trace widths of the metal traces are consistent, thereby facilitating signal stability.

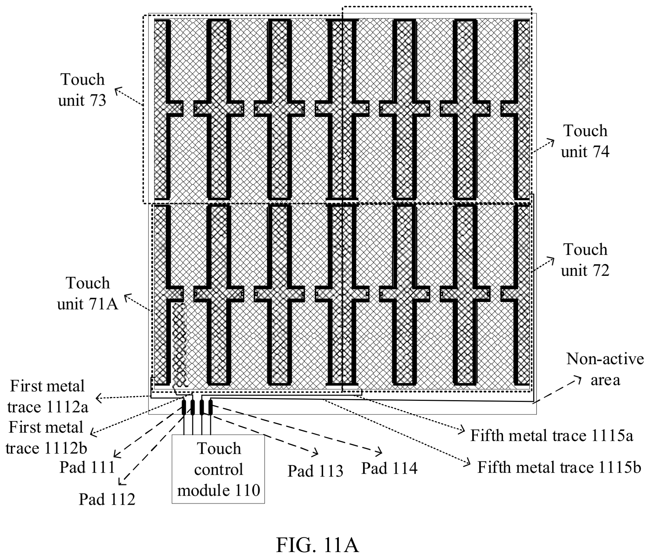

For example, a diagram of traces on the touch display panel may be shown in FIG. 11A. The touch display panel further includes a first metal trace and a pad. Each touch unit is located in the active area, and the first metal trace and the pad are located in a non-active area.

In the touch unit 71A, the second metal mesh in the second touch electrode area is connected to a first metal trace 1112a, and the first metal trace 1112a is connected to a touch control module 110 through a pad 111; and the first metal mesh in the first touch electrode area is connected to a first metal trace 1112b through the second metal trace, and the first metal trace 1112b is connected to the touch control module 110 through a pad 112.

In the touch unit 72, a first metal mesh in a first touch electrode area is connected to a fifth metal trace 1115a, the fifth metal trace 1115a is disposed in the non-active area, and the fifth metal trace 1115a is connected to the touch control module 110 through a pad 113. If the touch unit 72 and the touch unit 71A are located in a same row, a second metal mesh in a second touch electrode area of the touch unit 72 is connected to the second metal mesh in the second touch electrode area of the touch unit 71A, that is, the second metal mesh in the touch unit 72 is connected to the first metal trace 1112a.

In the touch unit 74, a second metal mesh in a second touch electrode area is connected to a fifth metal trace 1115b, the fifth metal trace 1115b is disposed in the non-active area, and the fifth metal trace 1115b is connected to the touch control module 110 through a pad 114. If the touch unit 74 and the touch unit 72 are located in a same column, a first metal mesh in a first touch electrode area of the touch unit 74 is connected to the first metal mesh in the first touch electrode area of the touch unit 72, that is, the first metal mesh of the touch unit 74 is connected to the fifth metal trace 1115a.

For the touch unit 73, if the touch unit 73 and the touch unit 74 are in a same row, the second metal mesh in the second touch electrode area of the touch unit 74 is connected to a second metal mesh in a second touch electrode area of the touch unit 73, that is, the second metal mesh of the touch unit 73 is connected to the fifth metal trace 1115b. In addition, if the touch unit 73 and the touch unit 71A are in a same column, a first metal mesh in a first touch electrode area of the touch unit 73 is connected to the first metal mesh in the first touch electrode area of the touch unit 71A, that is, the first metal mesh of the touch unit 73 is connected to the first metal trace 1112b through a second metal trace. In this case, resistance compensation for a trace resistance between the touch unit 73 and the pad 112 may also be implemented by using the second metal trace.

As shown in FIG. 11A, an example in which the touch display panel is specifically implemented as a mutual-capacitance display panel is used. A trace resistance between the touch unit 71A and the touch control module 110 is equal to a trace resistance between the touch unit 72 and the touch control module 110, and a trace resistance between the touch unit 73 and the touch control module 110 is equal to a trace resistance between the touch unit 74 and the touch control module 110. That is, trace resistances between touch units in a same row but different columns of the touch display panel and the touch control module 110 are equal.

During specific implementation, it may be understood that the pads may be connected to the touch control module 110 through traces of equal length, that is, trace resistances between the pads and the touch control module are equal. Alternatively, it may be considered that the pads are not far away from the touch control module, so that it may be considered that trace resistances between the touch units and the pads are trace resistances between the touch units and the touch control module.

Therefore, the trace resistance between the touch unit 71A and the touch control module 110 is a sum of resistances of the first metal trace 1112a, the second metal trace, and the first metal trace 1112b; the trace resistance between the touch unit 72 and the touch control module 110 is a sum of resistances of the fifth metal trace 1115a and the first metal trace 1112a; the trace resistance between the touch unit 74 and the touch control module 110 is a sum of resistances of the fifth metal trace 1115b and the fifth metal trace 1115a; and the trace resistance between the touch unit 73 and the touch control module 110 is a sum of resistances of the fifth metal trace 1115b, the second metal trace, and the first metal trace 1112b. In conclusion, a resistance value compensated by using the second metal trace is a resistance difference between the first metal trace 1112b and the fifth metal trace 1115a.

In this embodiment of this application, the second metal trace is additionally disposed in the first touch electrode area, and the second metal trace and the first metal mesh are located at a same metal layer, so that the second metal trace can be directly connected to the first metal mesh, and a small quantity of through holes is ensured. In addition, by using the second metal trace, compensation for the trace resistance between the touch unit 71A and the touch control module 110 can be implemented, so that the trace resistance between the touch unit 71A and the touch control module 110 is equal to the trace resistance between the touch unit 72 and the touch control module 110; and compensation for the trace resistance between the touch unit 74 and the touch control module 110 can be implemented, so that the trace resistance between the touch unit 74 and the touch control module 110 is equal to the trace resistance between the touch unit 73 and the touch control module 110.

During implementation of this embodiment of this application, resistance compensation for the traces between the touch units and the touch control module can be implemented, and the bezel of the touch display panel is not occupied, so that the bezel of the touch display panel is reduced, thereby ensuring the small bezel size.

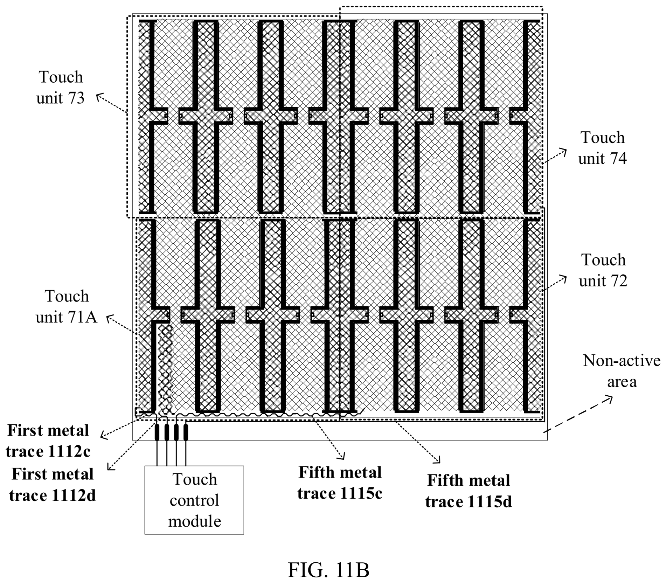

Optionally, in some feasible implementations, a diagram of traces on the touch display panel may alternatively be shown in FIG. 11B. Different from the traces on the touch display panel shown in FIG. 11A, in this embodiment of this application, each touch unit and a first metal trace may be disposed in the active area, and a pad is still located in a non-active area.

As shown in FIG. 11B, in the touch unit 71A, the second metal mesh in the second touch electrode area is connected to a first metal trace 1112c, and the first metal mesh in the first touch electrode area is connected to a first metal trace 1112d through the second metal trace. In this case, the first metal trace 1112c and the first metal trace 1112d extend according to a shape of pixel areas, and orthographic projections of the first metal trace 1112c and the first metal trace 1112d onto the display layer is in the light-shielding areas, and does not block light emitting of the pixel areas.

In the touch unit 72, a first metal mesh in a first touch electrode area is connected to a fifth metal trace 1115c, and the fifth metal trace 1115c is disposed in the active area. Similarly, the fifth metal trace 1115c extends according to a shape of the pixel areas, and an orthographic projection of the fifth metal trace 1115c onto the display layer is in the light-shielding areas, and does not block light emitting of the pixel areas.

In the touch unit 74, a second metal mesh in a second touch electrode area is connected to a fifth metal trace 1115d, and the fifth metal trace 1115d is disposed in the non-active area.

Resistances between the touch units and the touch control module are described above with reference to FIG. 11A. In this embodiment of this application, the effect of the embodiment described above with reference to FIG. 11A can be implemented, that is, the second metal trace is additionally disposed in the first touch electrode area, and the second metal trace and the first metal mesh are located at a same metal layer, so that the second metal trace can be directly connected to the first metal mesh, and a small quantity of through holes is ensured. In addition, in this embodiment of this application, the first metal trace connected to the second metal trace is disposed in the active area, which is different from that the first metal trace is disposed outside the active area in FIG. 11A, so that the bezel of the touch display panel can be further reduced in this embodiment of this application.

In this embodiment of this application, the second metal trace is additionally disposed in the first touch electrode area, and the second metal trace and the first metal mesh are located at the same metal layer. Although internal routing of the first touch electrode area is changed, a self-capacitance of a first touch electrode located in the first touch electrode area, a self-capacitance of a second touch electrode located in the second touch electrode area, and a mutual capacitance between the first touch electrode and the second touch electrode are not greatly affected. The following describes impact, of whether the second metal trace exists, on the self-capacitance of the first touch electrode, the self-capacitance of the second touch electrode, and the mutual capacitance between the first touch electrode and the second touch electrode with reference to Table 1 to Table 4.

For example, simulation of the trace resistance between the touch unit 71A and the touch control module 110 shown in FIG. 11B is shown in Table 1.

**Table 1**

| | |
|---|---|
| R_{1112d} | 27.09 Ω |
| R_{1112d} + R₃₂ | 620.56 Ω |
| R_{1115c} - R_{1112d} | 147.52 Ω |

R_{1112d} represents a resistance of the first metal trace 1112d, R_{1112d} + R₃₂ represents a sum of resistances of the first metal trace 1112d and the second metal trace, and R_{1115c} represents a resistance of the fifth metal trace 1115c. It can be learned from Table 1 that the trace resistance between the touch unit 71A and the touch control module 110 is 147.52 Ω greater than the trace resistance between the touch unit 72 and the touch control module 110, where 147.52 Ω is a theoretical resistance value to be compensated for the first metal trace 1112d by using the second metal trace, that is, a target resistance value of the second metal trace and the first metal trace 1112d is 147.52 Ω. In this case, an actual resistance that can be compensated for the first metal trace 1112d by using the second metal trace may reach 620.56 Ω-27.09 Ω=593.47 Ω, that is, the theoretical resistance value to be compensated for the first metal trace 1112d can be met by adjusting a trace length of the second metal trace.

In this case, the second metal trace is in the first touch electrode area, and is not only used as a resistance compensation trace of the touch unit 71A, but also participates in forming of an induction capacitor.

When there is no touch operation on the touch display panel, in two cases: a second metal trace exists and no second metal trace exists, simulation of a capacitance between the first touch electrode and a cathode (namely, the ground) and a capacitance between the second touch electrode and the ground is shown in Table 2.

**Table 2**

| | | Cathode/fF | Second touch electrode/fF | First touch electrode/fF |
|---|---|---|---|---|
| Cathode | No second metal trace exists | 15911.7 | 7564.66 | 8347.07 |
| | A second metal trace exists | 15879.4 | 7565.79 | 8313.63 |
| Second touch electrode | No second metal trace exists | 7564.66 | 7923.68 | 359.012 |
| | A second metal trace exists | 7565.79 | 7925.05 | 359.265 |
| First touch electrode | No second metal trace exists | 8347.07 | 359.012 | 8706.09 |
| | A second metal trace exists | 8313.63 | 359.265 | 8672.9 |

It can be learned from Table 2 that, when there is no touch operation on the touch display panel, and the first touch electrode and the second touch electrode do not sense a capacitance change, impact, of whether the second metal trace exists, on the capacitance between the first touch electrode and the ground and the capacitance between the second touch electrode and the ground is relatively small, and can be negligible. It may be understood that the capacitance between the first touch electrode and the ground and the capacitance between the second touch electrode and the ground are respectively the self-capacitance of the first touch electrode and the self-capacitance of the second touch electrode. That is, when there is no touch operation on the touch display panel, the second metal trace is disposed in the first touch electrode area, causing relatively small impact on the self-capacitance of the first touch electrode and the self-capacitance of the second touch electrode, which can be negligible.

The mutual capacitance Cₘ between the first touch electrode and the second touch electrode may be obtained according to Table 2, as shown in Table 3.

**Table 3**

| | No second metal trace exists | A second metal trace exists | Change amount |
|---|---|---|---|
| Cₘ | 359.01 fF | 359.26 fF | 0.25 fF |
| ΔCₘ | 66.99 fF | 66.55 fF | -0.444 fF |
| ΔCₘ/Cₘ | 18.66% | 18.52% | -0.14% |

It can be learned from Table 3 that, when there is no touch operation on the touch display panel, a change amount of the mutual capacitance Cₘ between the first touch electrode and the second touch electrode caused by using the second metal trace is 0.14%, that is, the second metal trace is disposed in the first touch electrode area, causing relatively small impact on the mutual capacitance between the first touch electrode and the second touch electrode, which can be negligible.

When there is a touch operation on the touch display panel, in two cases: a second metal trace exists and no second metal trace exists, simulation of a capacitance between the first touch electrode and the ground and a capacitance between the second touch electrode and the ground is shown in Table 4.

**Table 4**

| | | Cathode/fF | User finger/fF | Second touch electrode/fF | First touch electrode/fF |
|---|---|---|---|---|---|
| Cathode | No second metal trace exists | 16190.2 | 476.293 | 7473.03 | 8240.83 |
| | A second metal trace exists | 16159.1 | 477.792 | 7473.79 | 8207.54 |
| User finger | No second metal trace exists | 476.293 | 940.359 | 220.074 | 243.992 |
| | A second metal trace exists | 477.792 | 940.91 | 220.123 | 242.995 |
| Second touch electrode | No second metal trace exists | 7473.03 | 220.074 | 7985.12 | 292.018 |
| | A second metal trace exists | 7473.79 | 220.123 | 7986.63 | 292.715 |
| First touch electrode | No second metal trace exists | 8240.83 | 243.992 | 292.018 | 8776.84 |
| | A second metal trace exists | 8207.54 | 242.995 | 292.715 | 8743.25 |

It can be learned from Table 4 that, when there is a touch operation on the touch display panel, the self-capacitance of the first touch electrode is the capacitance between the first touch electrode and the cathode plus a capacitance between the first touch electrode and the user finger, and the self-capacitance of the second touch electrode is the capacitance between the second touch electrode and the cathode plus a capacitance between the second touch electrode and the user finger. Whether the second metal trace exists has relatively small impact on the capacitance between the first touch electrode and the cathode and the capacitance between the second touch electrode and the cathode, and whether the second metal trace exists also has relatively small impact on the capacitance between the first touch electrode and the user finger and the capacitance between the second touch electrode and the user finger. That is, when there is a touch operation on the touch display panel, the second metal trace is disposed in the first touch electrode area, causing relatively small impact on the self-capacitance of the first touch electrode and the self-capacitance of the second touch electrode, which can be negligible.

In conclusion, the second metal trace is additionally disposed in the first touch electrode area, so that compensation for resistances of the touch units can be implemented. The second metal trace and the first metal mesh are located at the same metal layer. After the second metal trace is additionally disposed, the impact on the self-capacitance of the first touch electrode, the self-capacitance of the second touch electrode, and the mutual capacitance between the first touch electrode and the second touch electrode can be negligible. Therefore, in this embodiment of this application, internal routing of the first touch electrode area is changed, and the second metal trace is added to the first touch electrode area, to implement resistance compensation for the traces between the touch units and the touch control module, so that the bezel size of the touch display panel can be reduced while maintaining relatively small impact on the self-capacitance of the first touch electrode, the self-capacitance of the second touch electrode, and the mutual capacitance between the first touch electrode and the second touch electrode, thereby ensuring the small bezel size.

In some feasible implementations, the touch unit 71A shown in FIG. 11A and FIG. 11B is located in the first row of the touch display panel. To be specific, resistance compensation for the touch units is initiated at a start portion of the touch display panel, so that signals of all the touch units on the touch display panel are even and consistent.

Optionally, in some feasible implementations, a routing manner of the touch unit 71A is applicable to a touch unit in any row or any column on the touch display panel.

As described above with reference to FIG. 8 to FIG. 11B, the second metal trace is disposed in the first touch electrode area, the second metal trace may be disposed at the first metal layer or the second metal layer of the touch display panel, and the second metal trace, the first metal mesh, and the second metal mesh are located at the same metal layer.

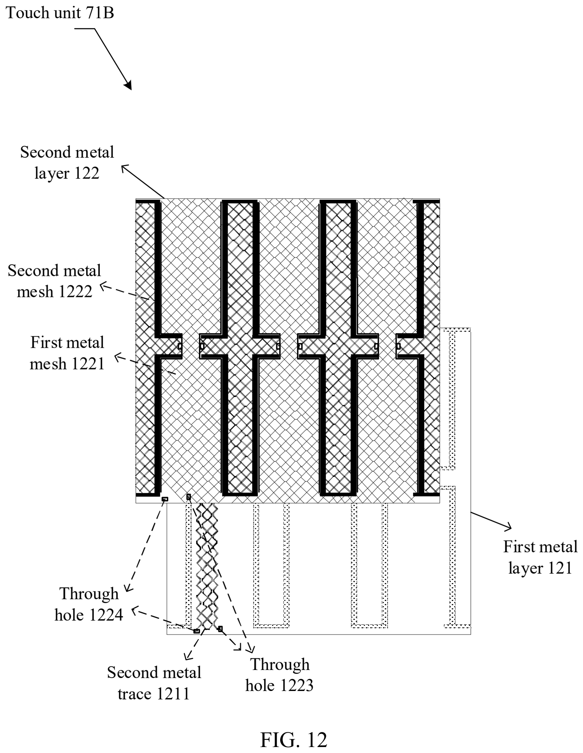

Optionally, in some feasible implementations, the at least one touch unit is disposed at the first metal layer and the second metal layer, and a second metal trace is disposed in a first touch electrode area of the at least one touch unit. The following provides descriptions with reference to FIG. 12 to FIG. 14B.

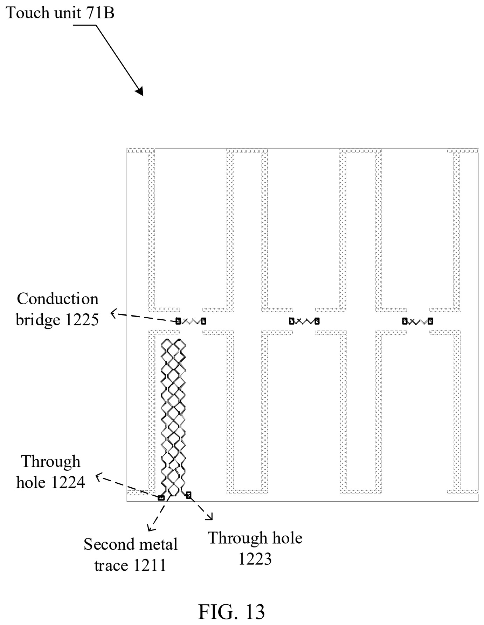

FIG. 12 is a diagram of a three-dimensional structure of a touch unit at a first metal layer and the second metal layer according to an embodiment of this application. FIG. 13 is a diagram of a planar structure of a touch unit according to an embodiment of this application. As shown in FIG. 12 and FIG. 13, a first metal mesh 1221 and a second metal trace 1211 are disposed in a first touch electrode area of a touch unit 71B, and a second metal mesh 1222 and a conduction bridge 1225 are disposed in a second touch electrode area of the touch unit 71B.

In FIG. 12 and FIG. 13, for example, the first metal mesh 1221 and the second metal mesh 1222 are located at a second metal layer 122, and the second metal trace 1211 and the conduction bridge 1225 are located at a first metal layer 121. In some feasible implementations, the first metal mesh and the second metal mesh may be located at the first metal layer, and the second metal trace and the conduction bridge are located at the second metal layer.

As shown in FIG. 12 and FIG. 13, one end of the second metal trace 1211 is connected to the first metal mesh 1221 through a through hole 1223. In this case, the other end of the second metal trace 1211 is connected to a touch control module through a pad. For example, the other end of the second metal trace 1211 may extend from the first metal layer 121 to the second metal layer 122 through a through hole 1224, and the second metal trace 1211 may be connected to the pad at the second metal layer 122, where the pad is further connected to the touch control module.

Fourth metal traces that the second metal mesh 1222 includes and that route at the first metal layer, and at least two through holes form the conduction bridge 1225. For specific descriptions of forming, refer to the conduction bridge 814 in FIG. 9B. Details are not described herein again.

For example, in the touch unit 71B, orthographic projections of the first metal mesh 1221 and the second metal trace 1211 onto a display layer are in light-shielding areas; and an orthographic projection of the second metal mesh 1222 onto the display layer is also in the light-shielding areas.

During implementation of this embodiment of this application, the orthographic projections of the first metal mesh, the second metal mesh, and the second metal trace onto the display layer are all in the light-shielding areas. In this way, resistance compensation for the traces on the touch display panel can be implemented in the first touch electrode area in an active area while a light emitting effect of the touch display panel is considered, so that a bezel of the touch display panel is reduced, thereby ensuring a small bezel size.

Optionally, in some feasible implementations, the first metal mesh 1221 includes a plurality of third metal traces, and the second metal mesh 1222 includes the plurality of fourth metal traces. In this case, a trace width of the second metal trace 1211, a trace width of the third metal trace, and a trace width of the fourth metal trace are within a preset range. An upper limit of the preset range is defined to avoid blocking light emitting of pixel areas, and a lower limit of the preset range is related to a manufacturing process of the touch display panel. In this embodiment of this application, the trace width of the second metal trace, a trace width of a first metal trace, and the trace width of the second metal trace are controlled to be within the preset range, to prevent the trace widths of the metal traces from being excessively wide and thereby blocking light emission of the pixel areas.

Further, the trace width of the second metal trace 1211, the trace width of the third metal trace, and the trace width of the fourth metal trace are the same. During implementation of this embodiment of this application, processing of the touch display panel is convenient, and the trace widths of the metal traces are consistent, thereby facilitating signal stability.

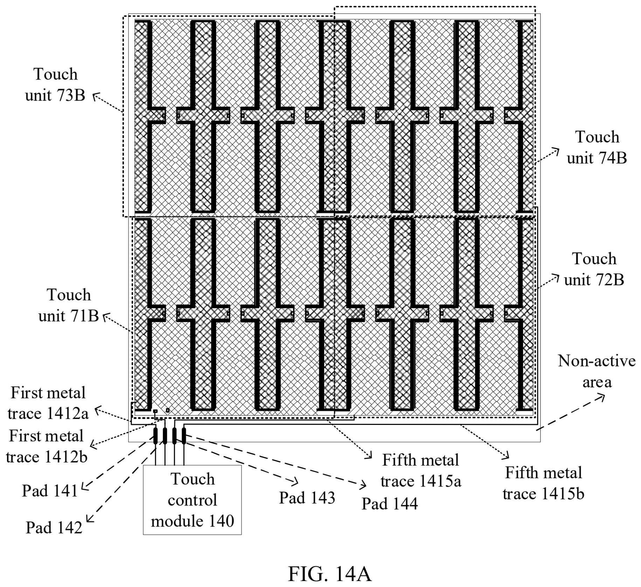

For example, a diagram of traces on the touch display panel may be shown in FIG. 14A. The touch display panel further includes the first metal trace and a pad. Each touch unit is located in the active area, and the first metal trace and the pad are located in a non-active area.

In the touch unit 71B, the second metal mesh in the second touch electrode area is connected to a first metal trace 1412a, and the first metal trace 1412a is connected to a touch control module 140 through a pad 141; and the first metal mesh in the first touch electrode area is connected to the second metal trace through a through hole, the second metal trace is connected to a first metal trace 1412b through another through hole, and the first metal trace 1412b is connected to the touch control module 140 through a pad 142. Different from the traces on the touch display panel shown in FIG. 11A, the second metal trace in this embodiment of this application is disposed at the first metal layer, and the second metal trace extends from the first metal layer to the second metal layer through the through holes. In this case, it can be seen from the diagram of the planar structure of the second metal layer of the touch display panel that the through hole is connected to the first metal trace 1412b.

In a touch unit 72B, a first metal mesh in a first touch electrode area is connected to a fifth metal trace 1415a, the fifth metal trace 1415a is disposed in the non-active area, and the fifth metal trace 1415a is connected to the touch control module 140 through a pad 143. If the touch unit 72B and the touch unit 71B are located in a same row, a second metal mesh in a second touch electrode area of the touch unit 72B is connected to the second metal mesh in the second touch electrode area of the touch unit 71B, that is, the second metal mesh in the touch unit 72B is connected to the first metal trace 1412a.

In a touch unit 74B, a second metal mesh in a second touch electrode area is connected to a fifth metal trace 1415b, the fifth metal trace 1415b is disposed in the non-active area, and the fifth metal trace 1415b is connected to the touch control module 140 through a pad 144. If the touch unit 74B and the touch unit 72B are located in a same column, a first metal mesh in a first touch electrode area of the touch unit 74B is connected to the first metal mesh in the first touch electrode area of the touch unit 72B, that is, the first metal mesh of the touch unit 74B is connected to the fifth metal trace 1415a.

For a touch unit 73B, if the touch unit 73B and the touch unit 74B are in a same row, the second metal mesh in the second touch electrode area of the touch unit 74B is connected to a second metal mesh in a second touch electrode area of the touch unit 73B, that is, the second metal mesh of the touch unit 73B is connected to the fifth metal trace 1415b. In addition, if the touch unit 73B and the touch unit 71B are in a same column, a first metal mesh in a first touch electrode area of the touch unit 73B is connected to the first metal mesh in the first touch electrode area of the touch unit 71B, that is, the first metal mesh of the touch unit 73B is connected to the second metal trace through a through hole, and the second metal trace is connected to the first metal trace 1412b through another through hole. In this case, resistance compensation for a trace resistance between the touch unit 73B and the pad 142 may also be implemented by using the second metal trace.

As shown in FIG. 14A, an example in which the touch display panel is specifically implemented as a mutual-capacitance display panel is used. A trace resistance between the touch unit 71B and the touch control module 140 is equal to a trace resistance between the touch unit 72B and the touch control module 140, and a trace resistance between the touch unit 73B and the touch control module 140 is equal to a trace resistance between the touch unit 74B and the touch control module 140. That is, trace resistances between touch units in a same row but different columns of the touch display panel and the touch control module 140 are equal.

Similarly, the pads may be connected to the touch control module 140 through traces of equal length, that is, trace resistances between the pads and the touch control module are equal. Alternatively, it may be considered that the pads are not far away from the touch control module, so that it may be considered that trace resistances between the metal traces in the touch electrode areas and the pads are trace resistances between the metal traces and the touch control module.

Therefore, the trace resistance between the touch unit 71B and the touch control module 140 is a sum of resistances of the first metal trace 1412a, the second metal trace, and the first metal trace 1412b; the trace resistance between the touch unit 72B and the touch control module 140 is a sum of resistances of the fifth metal trace 1415a and the first metal trace 1412a; the trace resistance between the touch unit 74B and the touch control module 140 is a sum of resistances of the fifth metal trace 1415b and the fifth metal trace 1415a; and the trace resistance between the touch unit 73B and the touch control module 140 is a sum of resistances of the fifth metal trace 1415b, the second metal trace, and the first metal trace 1412b. In conclusion, a resistance value compensated by using the second metal trace is a resistance difference between the first metal trace 1412b and the fifth metal trace 1415a.

In this embodiment of this application, the second metal trace is additionally disposed in the first touch electrode area, and the second metal trace and the first metal mesh are located at different metal layers. Compensation for the trace resistance between the touch unit 71B and the touch control module 140 is implemented, so that the trace resistance between the touch unit 71B and the touch control module 140 is equal to the trace resistance between the touch unit 72B and the touch control module 140; and compensation for the trace resistance between the touch unit 74B and the touch control module 140 is implemented, so that the trace resistance between the touch unit 74B and the touch control module 140 is equal to the trace resistance between the touch unit 73B and the touch control module 140.

During implementation of this embodiment of this application, the first metal mesh and the second metal trace are disposed at different layers, which can implement the beneficial effects of the embodiments described above with reference to FIG. 8 to FIG. 11B without changing a routing layout of the first metal mesh. In other words, during implementation of this embodiment of this application, resistance compensation for the traces between the touch units and the touch control module can be implemented without affecting the routing layout of the first metal mesh, and the bezel of the touch display panel is not occupied, so that the bezel of the touch display panel is reduced, thereby ensuring the small bezel size.

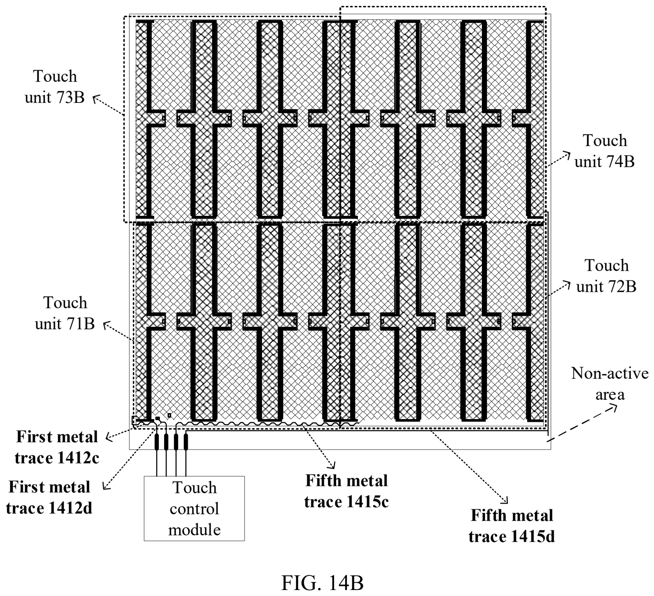

Optionally, in some feasible implementations, a diagram of traces on the touch display panel may alternatively be shown in FIG. 14B. Different from the traces on the touch display panel shown in FIG. 14A, in this embodiment of this application, each touch unit and a first metal trace may be disposed in the active area, and a pad is still located in a non-active area.

As shown in FIG. 14B, in the touch unit 71B, the second metal mesh in the second touch electrode area is connected to a first metal trace 1412c, and the first metal mesh in the first touch electrode area is connected to a first metal trace 1412d through the second metal trace. In this case, the first metal trace 1412c and the first metal trace 1412d are disposed outside the touch unit 71B but in the active area. For example, the first metal trace 1412c and the first metal trace 1412d extend according to a shape of pixel areas, and orthographic projections of the first metal trace 1412c and the first metal trace 1412d onto the display layer is in the light-shielding areas, and does not block light emitting of the pixel areas.

In a touch unit 72B, a first metal mesh in a first touch electrode is connected to a fifth metal trace 1415c, and the fifth metal trace 1415c is disposed in the active area. Similarly, the fifth metal trace 1415c extends according to a shape of the pixel areas, and an orthographic projection of the fifth metal trace 1415c onto the display layer is in the light-shielding areas, and does not block light emitting of the pixel areas.

In a touch unit 74B, a second metal mesh in a second touch electrode area is connected to a fifth metal trace 1415d, and the fifth metal trace 1415d is disposed in the non-active area.

Resistances between the touch units and the touch control module are described above with reference to FIG. 14A. In this embodiment of this application, the effect of the embodiment described above with reference to FIG. 14A can be implemented, that is, the second metal trace is additionally disposed in the first touch electrode area, which may not change a routing layout of the first metal mesh. In addition, in this embodiment of this application, the first metal trace connected to the second metal trace is disposed in the active area, which is different from that the first metal trace is disposed outside the active area in FIG. 14A, so that the bezel of the touch display panel can be further reduced in this embodiment of this application.

In this embodiment of this application, the second metal trace is additionally disposed in the first touch electrode area, and the second metal trace and the first metal mesh are located at different metal layers. Internal routing of the first touch electrode area is not changed, so that a self-capacitance of a first touch electrode located in the first touch electrode area, a self-capacitance of a second touch electrode located in the second touch electrode area, and a mutual capacitance between the first touch electrode and the second touch electrode are not greatly affected. The following describes impact, of whether the second metal trace exists, on the self-capacitance of the first touch electrode, the self-capacitance of the second touch electrode, and the mutual capacitance between the first touch electrode and the second touch electrode with reference to Table 5 to Table 8.

For example, simulation of the trace resistance between the touch unit 71B and the touch control module 140 shown in FIG. 14B is shown in Table 5.

**Table 5**

| | |
|---|---|
| R_{1412d} | 27.09 Ω |
| R_{1412d} + R₃₁ | 620.9 Ω |
| R_{1415c} - R_{1412d} | 147.52 Ω |

R_{1412d} represents a resistance of the first metal trace 1412d, R_{1412d} + R₃₁ represents a sum of resistances of the first metal trace 1412d and the second metal trace, and R_{1415c} represents a resistance of the fifth metal trace 1415c. With reference to Table 1 and Table 5, it can be learned that, the second metal trace is disposed at the first metal layer, which does not affect the resistances of the first metal trace and the fifth metal trace. Because the second metal trace is disposed at the first metal layer, and is connected to the second metal trace 1412d through the through hole, the sum of the resistances of the first metal trace 1412d and the second metal trace is greater than the sum of the resistances of the first metal trace 1112d and the second metal trace, that is, for the second metal traces having a same length, a resistance value compensated for the touch unit 71B by using the second metal trace disposed at the first metal layer is greater than a resistance value compensated for the touch unit 71B by using the second metal trace disposed at the second metal layer.

Similarly, in this embodiment of this application, a theoretical resistance value to be compensated for the first metal trace 1412d can also be met by adjusting a trace length of the second metal trace.

In this case, the second metal trace is in the first touch electrode area, and is not only used as a resistance compensation trace of the touch unit 71B, but also participates in forming of an induction capacitor.

When there is no touch operation on the touch display panel, in two cases: a second metal trace exists and no second metal trace exists, simulation of a capacitance between the first touch electrode and a cathode (namely, the ground) and a capacitance between the second touch electrode and the ground is shown in Table 6.

**Table 6**

| | | Cathode/fF | Second touch electrode/fF | First touch electrode/fF |
|---|---|---|---|---|
| Cathode | No second metal trace exists | 15911.7 | 7564.66 | 8347.07 |
| | A second metal trace exists | 15951.1 | 7565.72 | 8388.37 |
| Second touch electrode | No second metal trace exists | 7564.66 | 7923.68 | 359.012 |
| | A second metal trace exists | 7562.72 | 7923.22 | 360.502 |
| First touch electrode | No second metal trace exists | 8347.07 | 359.012 | 8706.09 |
| | A second metal trace exists | 8388.37 | 360.502 | 8748.87 |

It can be learned from Table 6 that, when there is no touch operation on the touch display panel, and the first touch electrode and the second touch electrode do not sense a capacitance change, impact, of whether the second metal trace exists, on the capacitance between the first touch electrode and the ground and the capacitance between the second touch electrode and the ground is relatively small, and can be negligible. It may be understood that the capacitance between the first touch electrode and the ground and the capacitance between the second touch electrode and the ground are respectively the self-capacitance of the first touch electrode and the self-capacitance of the second touch electrode. That is, when there is no touch operation on the touch display panel, the second metal trace is disposed in the first touch electrode area, causing relatively small impact on the self-capacitance of the first touch electrode and the self-capacitance of the second touch electrode, which can be negligible. With reference to Table 2 and Table 6, impact on the self-capacitance of the first touch electrode and the self-capacitance of the second touch electrode caused when the second metal trace is disposed at the first metal layer is less than impact on the self-capacitance of the first touch electrode and the self-capacitance of the second touch electrode caused when the second metal trace is disposed at the second metal layer.

The mutual capacitance Cₘ₁ between the first touch electrode and the second touch electrode may be obtained according to Table 6, as shown in Table 7.

**Table 7**

| | No second metal trace exists | A second metal trace exists | Change amount |
|---|---|---|---|
| Cₘ₁ | 359.01 fF | 360.50 fF | 1.49 fF |
| ΔCₘ₁ | 66.99 fF | 66.50 fF | -0.493 fF |
| ΔCₘ₁/Cₘ₁ | 18.66% | 18.45% | -0.21% |

It can be learned from Table 7 that, when there is no touch operation on the touch display panel, a change amount of the mutual capacitance Cₘ₁ between the first touch electrode and the second touch electrode caused by using the second metal trace is 0.21%, that is, the second metal trace is disposed in the first touch electrode area, causing relatively small impact on the mutual capacitance between the first touch electrode and the second touch electrode, which can be negligible. With reference to Table 3 and Table 7, the change amount (0.21%) of the mutual capacitance between the first touch electrode and the second touch electrode caused when the second metal trace is disposed at the first metal layer is greater than the change amount (0.14%) of the mutual capacitance between the first touch electrode and the second touch electrode caused when the second metal trace is disposed at the second metal layer. However, in this embodiment of this application, the second metal trace is disposed at the first metal layer, which does not change routing of the second metal trace, causing less impact on the self-capacitance of the first touch electrode and the self-capacitance of the second touch electrode.

When there is a touch operation on the touch display panel, in two cases: a second metal trace exists and no second metal trace exists, simulation of a capacitance between the first touch electrode and the ground and a capacitance between the second touch electrode and the ground is shown in Table 8.

**Table 8**

| | | Cathode/fF | User finger/fF | Second touch electrode/fF | First touch electrode/fF |
|---|---|---|---|---|---|
| Cathode | No second metal trace exists | 16190.2 | 476.293 | 7473.03 | 8240.83 |
| | A second metal trace exists | 16228.5 | 476.072 | 7470.59 | 8281.84 |
| User finger | No second metal trace exists | 476.293 | 940.359 | 220.074 | 243.992 |
| | A second metal trace exists | 476.072 | 941.038 | 220.415 | 244.551 |
| Second touch | No second metal trace exists | 7473.03 | 220.074 | 7985.12 | 292.018 |
| electrode | A second metal trace exists | 7470.59 | 220.415 | 7985.01 | 294.001 |
| First touch electrode | No second metal trace exists | 8240.83 | 243.992 | 292.018 | 8776.84 |
| | A second metal trace exists | 8281.84 | 244.551 | 294.001 | 8820.39 |

It can be learned from Table 8 that, when there is a touch operation on the touch display panel, the self-capacitance of the first touch electrode is the capacitance between the first touch electrode and the cathode plus a capacitance between the first touch electrode and the user finger, and the self-capacitance of the second touch electrode is the capacitance between the second touch electrode and the cathode plus a capacitance between the second touch electrode and the user finger. Whether the second metal trace exists has relatively small impact on the capacitance between the first touch electrode and the cathode and the capacitance between the second touch electrode and the cathode, and whether the second metal trace exists also has relatively small impact on the capacitance between the first touch electrode and the user finger and the capacitance between the second touch electrode and the user finger. That is, when there is a touch operation on the touch display panel, the second metal trace is disposed in the first touch electrode area, causing relatively small impact on the self-capacitance of the first touch electrode and the self-capacitance of the second touch electrode, which can be negligible.

In conclusion, the second metal trace is additionally disposed in the first touch electrode area, so that compensation for resistances of the touch units can be implemented. The second metal trace and the first metal mesh are located at different metal layers. After the second metal trace is added, the impact on the self-capacitance of the first touch electrode, the self-capacitance of the second touch electrode, and the mutual capacitance between the first touch electrode and the second touch electrode can be negligible. Therefore, in this embodiment of this application, the second metal trace that is located at a different metal layer from the first metal mesh is added to the first touch electrode area without changing internal routing of the first touch electrode area, so that resistance compensation of the touch units can be implemented without affecting the bezel size. Compared with the touch display panel shown in FIG. 11B, in this embodiment of this application, the second metal trace and the first metal mesh are disposed hierarchically, so that internal routing of the first touch electrode may not be changed.

In some feasible implementations, the touch unit 71B shown in FIG. 14A and FIG. 14B is located in the first column of the touch display panel. To be specific, resistance compensation for the touch units is initiated at a start portion of the touch display panel, so that signals of all the touch units on the touch display panel are even and consistent.

Optionally, in some feasible implementations, a routing manner of the touch unit 71B is applicable to any touch unit on the touch display panel.

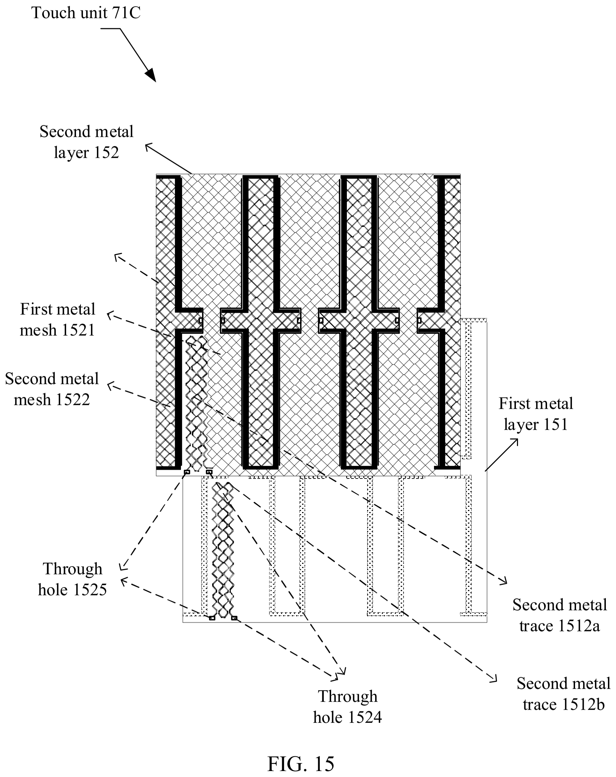

Optionally, in some feasible implementations, the at least one touch unit is disposed at the first metal layer and the second metal layer, a second metal trace is disposed in a first touch electrode area of the at least one touch unit, and the second metal trace may be disposed at both the first metal layer and the second metal layer. In this case, a part of the second metal trace and a first metal mesh are located at a same metal layer, and the other part of the second metal trace and the first metal mesh are located at different metal layers. FIG. 15 is a diagram of another three-dimensional structure of a touch unit at a first metal layer and a second metal layer according to an embodiment of this application. As shown in FIG. 15, a first metal mesh 1521, a second metal trace 1512a, and a second metal trace 1512b are disposed in a first touch electrode area of a touch unit 71C, and a second metal mesh 1522 and a conduction bridge (not shown in FIG. 15) are disposed in a second touch electrode area of the touch unit 71C.

The second metal trace 1512a, the first metal mesh 1521, and the second metal mesh 1522 are located at a same metal layer, and the second metal trace 1512b and the first metal mesh 1521 are located at different metal layers.

In FIG. 15, for example, the first metal mesh 1521, the second metal mesh 1522, and the second metal trace 1512a are located at a second metal layer 152, and the second metal trace 1512b and the conduction bridge are located at a first metal layer 151.

As shown in FIG. 15, one end of the second metal trace 1512b is connected to one end of the second metal trace 1512a through a through hole 1525, and the other end of the second metal trace 1512a is connected to the first metal mesh 1521. The other end of the second metal trace 1512b extends from the first metal layer 151 to the second metal layer 152 through a through hole 1524, and the other end of the second metal trace 1512b may be connected to a pad at the second metal layer, where the pad is further connected to a touch control module.

In some feasible implementations, shapes of the first metal mesh 1521, the second metal mesh 1522, and the second metal trace in the touch unit 71C are respectively the same as shapes of the first metal mesh, the second metal mesh, and the second metal trace in the foregoing touch unit 71A.

Optionally, trace widths of a plurality of third metal traces forming the first metal mesh 1521, trace widths of a plurality of fourth metal traces forming the second metal mesh 1522, and a trace width of the second metal trace are within a preset range. Further, the trace width of the second metal trace, the trace width of the third metal trace, and the trace width of the fourth metal trace are the same.

In this embodiment of this application, the second metal trace is additionally disposed in the first touch electrode area, and the second metal trace is separately disposed at different metal layers. For example, a part of the second metal trace and the first metal mesh are located at different metal layers, and a part of the second metal trace and the first metal mesh are located at a same metal layer. In this case, a resistance compensation value of the first metal conducting wire can be increased. In other words, during implementation of this embodiment of this application, a capability of resistance compensation for the traces between the touch unit and the touch control module is enhanced, which is more suitable for being applied to a touch display panel with a large size and a narrow bezel. In addition, a bezel of the touch display panel may not be occupied, so that the bezel of the touch display panel is reduced, thereby ensuring the small bezel size.

Optionally, in some feasible implementations, a routing manner of the touch unit 71C is applicable to any touch unit on the touch display panel.

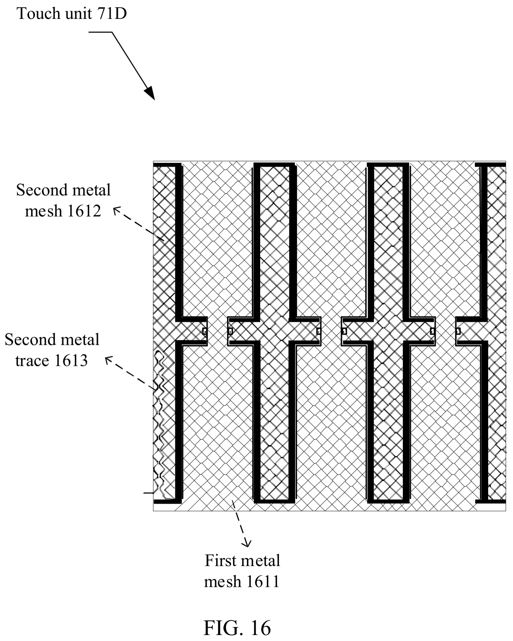

The foregoing describes, with reference to FIG. 8 to FIG. 15, an example in which a second metal trace is disposed in a first touch electrode area of a touch unit. The following describes, with reference to FIG. 16 to FIG. 20, that a second metal trace is disposed in a second touch electrode area of a touch unit.

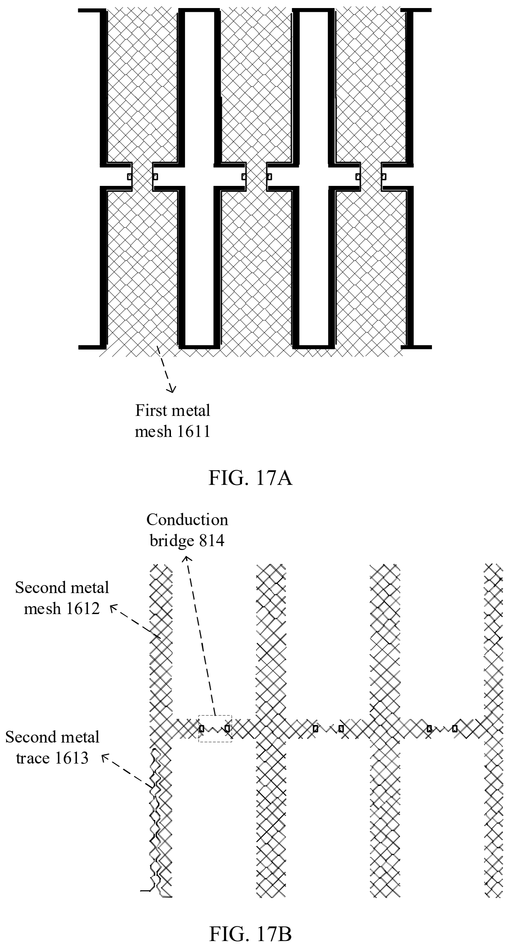

In some feasible implementations, the at least one touch unit is disposed at the first metal layer, or the at least one touch unit is disposed at the second metal layer, and a second metal trace is disposed in a second touch electrode area of the at least one touch unit. FIG. 16 is a diagram of another planar structure of a touch unit according to an embodiment of this application. FIG. 17A is a diagram of an exploded structure of the touch unit shown in FIG. 16. FIG. 17B is a diagram of another exploded structure of the touch unit shown in FIG. 16. As shown in FIG. 16 and FIG. 17A, a first metal mesh 1611 is disposed in a first touch electrode area of a touch unit 71D.

As shown in FIG. 16 and FIG. 17B, a second metal mesh 1612 and a second metal trace 1613 are disposed in a second touch electrode area of the touch unit 71D. In this case, the first metal mesh 1611, the second metal mesh 1612, and the second metal trace 1613 are located at a same metal layer, and the second metal trace 1613 may be directly connected to the second metal mesh 1612. For example, the first metal mesh 1611, the second metal mesh 1612, and the second metal trace 1613 may be located at the first metal layer, or the first metal mesh 1611, the second metal mesh 1612, and the second metal trace 1613 may be located at the second metal layer.

In addition, a conduction bridge is further disposed in the second touch electrode area. For example, the second metal mesh 1612 is located at the second metal layer. Fourth metal traces that the second metal mesh 1612 includes and that route at the first metal layer, and at least two through holes form the conduction bridge.

In some feasible implementations, shapes of the first metal mesh 1521, the second metal mesh 1522, and the second metal trace in the touch unit 71C are respectively the same as shapes of the first metal mesh, the second metal mesh, and the second metal trace in the foregoing touch unit 71A.

Optionally, trace widths of a plurality of third metal traces forming the first metal mesh 1521, trace widths of the plurality of fourth metal traces forming the second metal mesh 1522, and a trace width of the second metal trace are within a preset range. Further, the trace width of the second metal trace, the trace width of the third metal trace, and the trace width of the fourth metal trace are the same.

In this embodiment of this application, the second metal trace is additionally disposed in the second touch electrode area, to implement the effects of the embodiments described above with reference to FIG. 8 to FIG. 9B, that is, to implement resistance compensation for the traces between the touch unit and a touch control module, so that a bezel size of the touch display panel can be reduced while maintaining relatively small impact on a self-capacitance of a first touch electrode, a self-capacitance of a second touch electrode, and a mutual capacitance between the first touch electrode and the second touch electrode, thereby ensuring the small bezel size.

Optionally, in some feasible implementations, a routing manner of the touch unit 71D is applicable to any touch unit on the touch display panel.

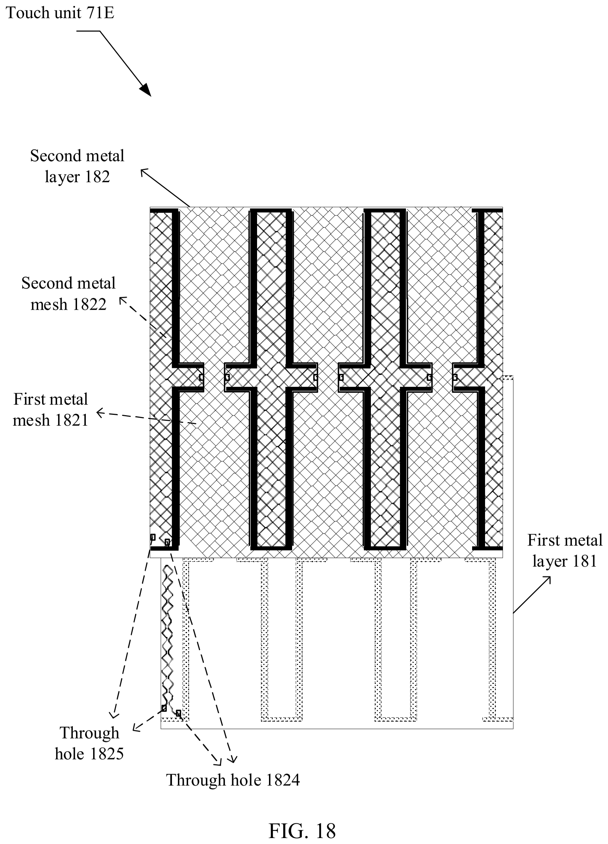

Optionally, in some feasible implementations, the at least one touch unit is disposed at the first metal layer and the second metal layer, and a second metal trace is disposed in a first touch electrode area of the at least one touch unit. The following provides descriptions with reference to FIG. 18 to FIG. 20.

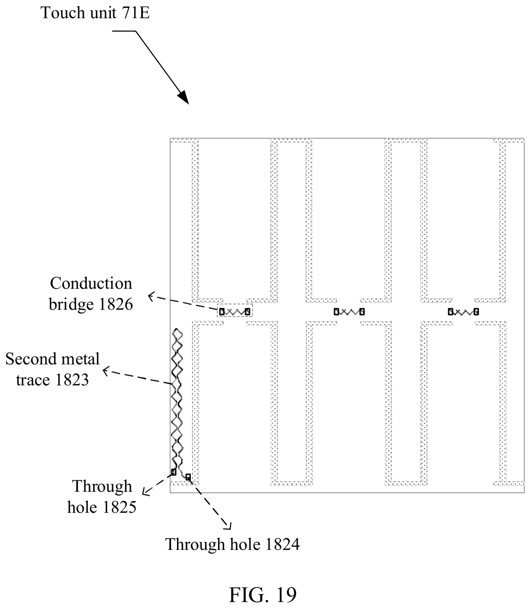

FIG. 18 is a diagram of another three-dimensional structure of a touch unit at a first metal layer and a second metal layer according to an embodiment of this application. FIG. 19 is a diagram of another planar structure of a touch unit according to an embodiment of this application. As shown in FIG. 18 and FIG. 19, a first metal mesh 1821 is disposed in a first touch electrode area of a touch unit 71E, and a second metal mesh 1822, a second metal trace 1823, and a conduction bridge 1826 are disposed in a second touch electrode area of the touch unit 71E.

In FIG. 18 and FIG. 19, for example, the first metal mesh 1821 and the second metal mesh 1822 are located at a second metal layer 182, and the second metal trace 1823 and the conduction bridge 1826 are located at a first metal layer 181. In some feasible implementations, the first metal mesh and the second metal mesh may be located at the first metal layer, and the second metal trace and the conduction bridge are located at the second metal layer.

As shown in FIG. 18 and FIG. 19, one end of the second metal trace 1823 is connected to the second metal mesh 1822 through a through hole 1824. In this case, the other end of the second metal trace 1823 is connected to a touch control module through a pad. For example, the other end of the second metal trace 1823 may extend from the first metal layer 181 to the second metal layer 182 through a through hole 1825, and the second metal trace 1823 may be connected to the pad at the second metal layer 182, where the pad is further connected to the touch control module.

Fourth metal traces that the second metal mesh 1822 includes and that route at the first metal layer, and at least two through holes form the conduction bridge 1826.

In some feasible implementations, shapes of the first metal mesh 1821, the second metal mesh 1822, and the second metal trace in the touch unit 71E are respectively the same as shapes of the first metal mesh, the second metal mesh, and the second metal trace in the foregoing touch unit 71A.

Optionally, trace widths of a plurality of third metal traces forming the first metal mesh 1821, trace widths of the plurality of fourth metal traces forming the second metal mesh 1822, and a trace width of the second metal trace 1823 are within a preset range. Further, the trace width of the second metal trace, the trace width of the third metal trace, and the trace width of the fourth metal trace are the same.

In this embodiment of this application, the second metal trace is additionally disposed in the second touch electrode area, and the second metal trace and the second metal mesh are located at different metal layers, to implement the effects of the embodiments described above with reference to FIG. 12 and FIG. 13, that is, to implement resistance compensation for the traces between the touch unit and the touch control module, so that a bezel size of the touch display panel can be reduced while maintaining relatively small impact on a self-capacitance of a first touch electrode, a self-capacitance of a second touch electrode, and a mutual capacitance between the first touch electrode and the second touch electrode without affecting a routing layout of the second metal mesh, thereby ensuring the small bezel size.

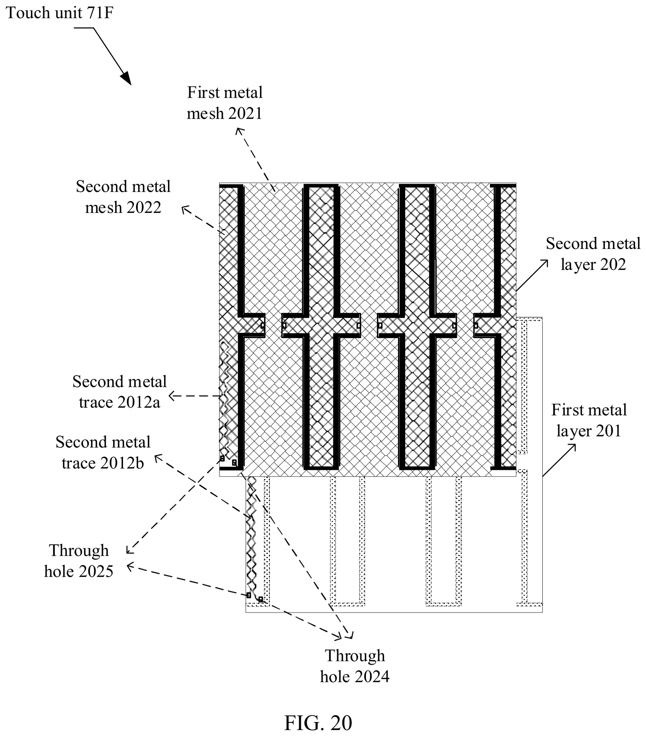

Optionally, in some feasible implementations, the at least one touch unit is disposed at the first metal layer and the second metal layer, a second metal trace is disposed in a second touch electrode area of the at least one touch unit, and the second metal trace may be disposed at both the first metal layer and the second metal layer. In this case, a part of the second metal trace and a second metal mesh are located at a same metal layer, and the other part of the second metal trace and the second metal mesh are located at different metal layers. FIG. 20 is a diagram of another three-dimensional structure of a touch unit at a first metal layer and a second metal layer according to an embodiment of this application. As shown in FIG. 20, a first metal mesh 2021 is disposed in a first touch electrode area of a touch unit 71F, and a second metal mesh 2022, a second metal trace 2012a, a second metal trace 2012b, and a conduction bridge (not shown in FIG. 20) are disposed in a second touch electrode area of the touch unit 71F.

The second metal trace 2012a, the first metal mesh 2021, and the second metal mesh 2022 are located at a same metal layer, and the second metal trace 2012b and the second metal mesh 2022 are located at a same metal layer.

In FIG. 20, for example, the first metal mesh 2021, the second metal mesh 2022, and the second metal trace 2012a are located at a second metal layer 202, and the second metal trace 2012b and the conduction bridge are located at a first metal layer 201.

As shown in FIG. 20, one end of the second metal trace 2012b is connected to one end of the second metal trace 2012a through a through hole 2025 (namely, a second through hole), and the other end of the second metal trace 2012a is connected to the second metal mesh 2022. The other end of the second metal trace 2012b extends from the first metal layer 201 to the second metal layer 202 through a through hole 2024, and the other end of the second metal trace 2012b may be connected to a pad at the second metal layer, where the pad is further connected to a touch control module.

In some feasible implementations, shapes of the first metal mesh 2021, the second metal mesh 2022, and the second metal trace in the touch unit 71E are respectively the same as shapes of the first metal mesh, the second metal mesh, and the second metal trace in the foregoing touch unit 71A.

Optionally, trace widths of a plurality of third metal traces forming the first metal mesh 2021, trace widths of a plurality of fourth metal traces forming the second metal mesh 2022, and a trace width of the second metal trace are within a preset range. Further, the trace width of the second metal trace, the trace width of the third metal trace, and the trace width of the fourth metal trace are the same.

In this embodiment of this application, the second metal trace is additionally disposed in the second touch electrode area, and the second metal trace is separately disposed at different metal layers. For example, a part of the second metal trace and the second metal mesh are located at different metal layers, and a part of the second metal trace and the second metal mesh are located at a same metal layer. In this case, during implementation of this embodiment of this application, the effect of the embodiment described above with reference to FIG. 15 can be implemented, that is, a resistance compensation value of the first metal conducting wire can be increased. A capability of resistance compensation for the traces between the touch unit and the touch control module is enhanced, which is more suitable for being applied to a touch display panel with a large size and a narrow bezel. In addition, a bezel of the touch display panel may not be occupied, so that the bezel of the touch display panel is reduced, thereby ensuring the small bezel size.

Optionally, in some feasible implementations, the touch units described above with reference to FIG. 8 to FIG. 20, such as the touch unit 71A, the touch unit 71B, the touch unit 71C, the touch unit 71D, the touch unit 71E, and the touch unit 71F, may be combined with each other. For example, in a touch display panel, trace resistance compensation manners shown by the touch unit 71A and the touch unit 71C may be used. To be specific, a second metal trace is disposed in both a first touch electrode area and a second touch electrode area, the second metal trace disposed in the first touch electrode area and the second metal trace disposed in the second touch electrode area are located at a same metal layer, and resistance compensation for traces between the touch units and a touch control module is implemented. For another example, trace resistance compensation manners shown by the touch unit 71A, the touch unit 71B, and the touch unit 71D may be used. To be specific, a second metal trace is disposed in both a first touch electrode area and a second touch electrode area, but the second metal trace disposed in the first touch electrode area and the second metal trace disposed in the second touch electrode area are located at different metal layers. Details are not described herein again.

It should be noted that the terms "first" and "second" are merely intended for a purpose of description, and shall not be understood as an indication or implication of relative importance.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A touch display panel, wherein the touch display panel comprises a display layer, an encapsulation layer, and a touch layer group that are sequentially disposed in a stacked manner, and the touch layer group is located on a side that is of the encapsulation layer and that is away from the display layer;
a plurality of touch units arranged in an array, a first metal trace, and a pad are disposed in the touch layer group, and at least one touch unit comprises a first touch electrode area and a second touch electrode area;
a first metal mesh is disposed in the first touch electrode area, a second metal mesh is disposed in the second touch electrode area, and the first metal mesh and the second metal mesh form an induction capacitor; and
a second metal trace is disposed in at least one of the first touch electrode area and the second touch electrode area, the second metal trace is used to connect a metal mesh in a touch electrode area in which the second metal trace is located to one end of the first metal trace, the other end of the first metal trace is connected to the pad, and the second metal trace is used to adjust a trace resistance between the at least one touch unit and the pad.

2. The touch display panel according to claim 1, wherein a plurality of pixel areas arranged in an array and a light-shielding area between adjacent pixel areas are disposed at the display layer, and orthographic projections of the first metal mesh, the second metal mesh, and the second metal trace onto the display layer fall within the light-shielding areas.

3. The touch display panel according to either of claims 1 and 2, wherein the first metal mesh comprises a plurality of third metal traces, and the second metal mesh comprises a plurality of fourth metal traces.

4. The touch display panel according to claim 3, wherein a trace width of the first metal trace, a trace width of the second metal trace, and a trace width of the third metal trace are the same.

5. The touch display panel according to any one of claims 1 to 4, wherein the touch layer group is formed by stacking a first metal layer, an insulation layer, and a second metal layer in a thickness direction of the touch display panel, and the insulation layer is disposed between the first metal layer and the second metal layer; and
the at least one touch unit is disposed at the first metal layer, or the at least one touch unit is disposed at the second metal layer, or the at least one touch unit is disposed at the first metal layer and the second metal layer.

6. The touch display panel according to claim 5, wherein the at least one touch unit is disposed at the first metal layer, or the at least one touch unit is disposed at the second metal layer; and
when the second metal trace is disposed in the first touch electrode area of the at least one touch unit, the second metal trace is directly connected to the first metal mesh in the first touch electrode area.

7. The touch display panel according to claim 5, wherein the at least one touch unit is disposed at the first metal layer, or the at least one touch unit is disposed at the second metal layer; and
when the second metal trace is disposed in the second touch electrode area of the at least one touch unit, the second metal trace is directly connected to the second metal mesh in the second touch electrode area.

8. The touch display panel according to claim 5, wherein the at least one touch unit is disposed at the first metal layer and the second metal layer, and a first through hole is provided at the insulation layer; and
when the second metal trace is disposed in the first touch electrode area of the at least one touch unit, the second metal trace is located at the first metal layer, the first metal mesh in the first touch electrode area is located at the second metal layer, and the second metal trace is connected to the first metal mesh through the first through hole.

9. The touch display panel according to claim 5, wherein the at least one touch unit is disposed at the first metal layer and the second metal layer, and a second through hole is provided at the insulation layer; and
when the second metal trace is disposed in the second touch electrode area of the at least one touch unit, the second metal trace is located at the first metal layer, the second metal mesh in the second touch electrode area is located at the second metal layer, and the second metal trace is connected to the second metal mesh through the second through hole.

10. The touch display panel according to any one of claims 1 to 9, wherein the at least one touch unit is arranged in a first row or a first column of the array.

11. A touch display apparatus, wherein the touch display apparatus comprises a touch control module and the touch display panel according to any one of claims 1 to 10.

12. An electronic device, wherein the electronic device comprises a controller and the touch display apparatus according to claim 11.
